# EUROPEAN PATENT APPLICATION

(11) **EP 1 804 469 A2**
(43) Date of publication of application: **04.07.2007**
(21) Application number: 06127272.0
(22) Date of filing: 28.12.2006
(51) Int. Cl.: H04M 1/02, H05K 5/00

(54) **Metal Case for Portable Terminal and Method for Manufacturing the Same**

(30) Priority: 29.12.2005 KR 20050133757
(71) Applicant: Samsung Electronics Co., Ltd., Suwon-si, Gyeonggi-Do (KR)
(72) Inventor: CHO, Young-In, Gyeonggi-do (KR)
(74) Representative: Zimmer, Franz-Josef

(57) **Abstract**

Disclosed are a metal case (10,100,300) for a portable terminal and a method for manufacturing the same. The metal case for the electronic device is manufactured by a method including manufacturing an initial metal case (20,200,400) using electro-forming method; trimming the initial metal case (20,200,400) or removing foreign material from the initial metal case, to form a shape of the metal case; and insert-injecting plastic material for an inner and/or outer surface of the metal case (10,100,300).

## Description

### BACKGROUND OF THE INVENTION

### 1. Field of the Invention

The present invention relates to a metal case for a portable terminal and a method for manufacturing the same, and more particularly to a metal case for a portable terminal, which can be produced with metal using an electro-forming method while being made by insert-injecting plastic, and a method for manufacturing the same.

### 2. Description of the Related Art

In general, a "portable communication terminal" refers to an electronic device which a user can carry while wirelessly communicating with another user. Such a portable communication terminal includes hand-held phones, CT-2 cellular phones, digital phones, Personal Communication Service phones (PCS phones), Personal Digital Assistants (PDAs), etc. Conventional portable terminals may be classified into various types according to their appearance, such as bar-type portable terminals, flip-type portable terminals, and folder-type portable terminals. The bar-type portable terminal has a single housing shaped like a bar The flip-type portable terminal has a flip panel which is pivotably mounted to a bar-shaped housing by a hinge unit. The folder-type portable terminal has a folder coupled to a single bar-shaped housing by a hinge unit in such a manner that the folder can rotate in order to be folded on or unfolded from the housing. Further, portable terminals may be classified as neck wearable type terminals and wrist wearable type terminals, according to the position at or the way in which a user wears the terminal. The neck wearable type terminal is one which a user wears around the neck using a lanyard or necklace, while the wrist wearable type terminal is one which a user wears around the wrist. Additionally, portable terminals may be classified as rotation-type terminals and sliding-type terminals according to the methods of opening and closing the terminals. In the rotation-type portable terminal, two housings are coupled to each other in a manner that one housing rotates to be opened or closed relative to the other while facing each other. In the sliding-type portable terminal, two housings are coupled to each other in a manner that one housing slides to be opened or closed relative to the other. The various classifications of portable terminals are easily understood by those skilled in the art.

In consideration of portability, design of such a portable terminal has tended toward lightness and compactness. Recently, slim sized portable terminals, being is very thin, have been widely used.

Generally, a case for a portable terminal is manufacturing by injecting plastic. However, as the portable terminal has a thickness which is thin according to the recent tendency of slimness thereof, the plastic case does not supply sufficient rigidity to the portable terminal, thereby causing the portable terminal to warp or twist.

As described above, as recent portable terminals have been adopting slimness, plastic cases are being replaced by metal cases in order to maintain rigidity of the cases for portable terminals.

A method for manufacturing metal cases includes a die-casting method and a pressing method.

Generally, according to the die-casting method, molten metal is injected in a mold which is accurately worked, and then solidified, thereby providing high quality castings which have very accurate dimensions similar to that of the mold and a clean surface. Aluminum alloys, in which one or more special elements, such as copper, silicon, manganese, nickel, etc., are added to aluminum, are mainly used as alloys for die-casting.

In the die-casting method, first, the mold is positioned at a predetermined location. Then, the reciprocating movement of a ram mounted in the cylinder is adjusted. Next, hoses for providing a cooling agent and a release agent are connected to the mold. Then, the mold is preheated. Valves are operated according to a size and a shape of castings and the kind of material for the castings, so as to control the sprayed pressure of the cooling agent and the release agent, or so as to control an injection velocity according to a manual operation or an automatic operation. Continuously, air is sprayed in order to remove foreign material, such as metal remnants attached to a surface of the mold. Further, a release agent and lubricant are coated on a molding box of the mold and a plunger so that the castings can be released from the mold each time that the molding is performed.

In manufacturing castings using the conventional die-casting method, when molten aluminum alloy is injected into the mold, the molten alloy is injected within a short time and thus air is introduced into the mold, thereby decreasing the workability of the products during the solidification of the molten alloy, and causing a defect in which a solidified structure is uneven.

Further, according to the conventional die-casting method, there are problems in that the above-mentioned post process is complicated, the manufacturing cost increases, and the yield of the product is very low.

According to the pressing method, pressure is applied to the plate material so as to transform the shape of the plate, thereby forming a panel. Hereinafter, the pressing method will be described.

A panel having a plate shape is inserted into a press apparatus and seated on a lower molding box of a mold. Then, an upper molding box of the mold is positioned on the lower molding box and is fixed by means of a fixing element. Next, a plunger provided in the lower molding box is upwardly pressed, thereby transforming the panel according to the curve of the upper molding box and the shape of the plunger (not shown).

The conventional pressing method can be applied for the panel which has a simple curve. However, it is difficult to manufacture a product having a complicated curve, such as a case for a portable terminal.

### SUMMARY OF THE INVENTION

Accordingly, the present invention has been made to solve the above-mentioned problems occurring in the prior art, and an object of the present invention is to provide a metal case for a portable terminal and a method for manufacturing the same, which is manufactured using an electro-forming method, thereby improving rigidity of the case, simplifying manufacturing processes, and increasing yield of the product so as to secure mass-production.

Another object of the present invention is to provide a metal case for a portable terminal and a method for manufacturing the same, in which the case for the portable terminal is made of metal by using an electro-forming method, and is then coated with plastic by insert-injecting plastic, thereby providing a desired strength to the product so as to increase rigidity of the product.

Still another object of the present invention is to provide a metal case for a portable terminal and a method for manufacturing the same, in which the case for the portable terminal is made of metal by using an electro-forming method, and is then coated with plastic by insert-injecting plastic, thereby simplifying manufacturing processes and decreasing a thickness of the product so as to reduce the manufacturing cost.

Yet another object of the present invention is to provide a metal case for a portable terminal and a method for manufacturing the same, in which the case for the portable terminal is made of metal by using an electro-forming method, and then an outer surface of the case is coated with plastic material by insert-injecting plastic, while characters are embossed on the outer surface of the case so as to emboss characters on the products during the insert-injection of the plastic.

Still another object of the present invention is to provide a metal case and a method for manufacturing the same, in which the case for the portable terminal is made of metal by using an electro-forming method, and then an outer surface of the case is coated with plastic material by insert-injecting plastic, thereby easily manufacturing the case without a separate insulation process for the product.

In order to accomplish these objects, according to a first aspect of the present invention, there is provided a metal case for a portable terminal, which is manufactured by a method including manufacturing a metal case by using an electro-forming method; and insert-injecting a plastic material for an inner surface of the metal case.

According to a second aspect of the present invention, there is provided a method for manufacturing a metal case for a portable terminal, which includes manufacturing an initial metal case using an electro-forming method; trimming the initial metal case or removing foreign material from the initial metal to obtain the metal case for the portable terminal; painting and insulating the metal case for the portable terminal; and insert-injecting plastic for an inner surface of the metal case for the portable terminal.

According to a third aspect of the present invention, there is provided a metal case for a portable terminal, which is manufactured by a method including manufacturing an initial metal case using an electro-forming method; trimming the initial metal case or removing foreign material from the initial metal case to form a shape of the metal case; and insert-injecting plastic material for an outer surface of the metal case.

According to a fourth aspect of the present invention, there is provided a method for manufacturing a metal case for a portable terminal, including manufacturing an initial metal case using an electro-forming method and embossing characters on an outer surface of the metal case; trimming the initial metal case or removing foreign material from the initial metal case to obtain the metal case for the portable terminal; painting and insulating the metal case for the portable terminal; and insert-injecting plastic material for and embossing the characters on the outer surface of the metal case for the portable terminal.

According to a fifth aspect of the present invention, there is provided a metal case for a portable terminal, which is manufacture by a method including manufacturing an initial metal case using electro-forming method; trimming the initial metal case or removing foreign material from the initial metal case to form a shape of the metal case; and insert-injecting plastic material for inner and outer surfaces of the metal case.

According to a sixth aspect of the present invention, there is provided a method for manufacturing a metal case for a portable terminal, including manufacturing an initial metal case by using an electro-forming method; trimming the initial metal case and removing foreign material from the initial metal case to obtain the metal case for the portable terminal; and insert-injecting plastic material for inner and outer surfaces of the metal case for the portable terminal obtained from the metal case trimming step.

### BRIEF DESCRIPTION OF THE DRAWINGS

The above and other features and advantages of the present invention will be more apparent from the following detailed description taken in conjunction with the accompanying drawings, in which:
FIG 1 is a view illustrating a process for manufacturing a metal case for a portable terminal using an electro-forming method, according to a first embodiment of the present invention;
FIG 2 is a view showing a master mold and the metal case for the portable terminal according to the first embodiment of the present invention, before the separation of the metal case from the master mold;
FIG 3 is a view showing the master mold and the metal case for the portable terminal according to the first embodiment of the present invention, after the separation of the metal case from the master mold;
FIG 4 is a view showing the metal case for the portable terminal according to the first embodiment of the present invention, in which the plastic is molded on the inner surface of the metal case by the insert-injection molding;
FIG 5 is a flowchart illustrating a method for producing a metal case for the portable terminal shown in FIG 4;
FIG 6 is a view showing a master mold and a metal case for a portable terminal according to the second embodiment of the present invention;
FIG. 7 is a view showing the metal case for the portable terminal according to the second embodiment of the present invention, in which the plastic is molded on the outer surface of the metal case by insert-injection molding;
FIG 8 is a flowchart illustrating the method for manufacturing the metal case for the portable terminal according to the second embodiment of the present invention;
FIG 9 is a view showing a master mold and a metal case for a portable terminal according to a third embodiment of the present invention, after the separation of the metal case from the master mold;
FIG 10 is a view showing the metal case for the portable terminal according to the third embodiment of the present invention, in which the plastic is insert-injected for the inner and outer surfaces of the metal case.
FIG 11 is a sectional view showing the metal case for the portable terminal, taken along a line A-A' in FIG 10; and
FIG 12 is a flowchart illustrating a method for producing the metal case of the portable terminal according to the third embodiment of the present invention.

### DETAILED DESCRIPTION OF THE PREFERRED EMBODIMENT

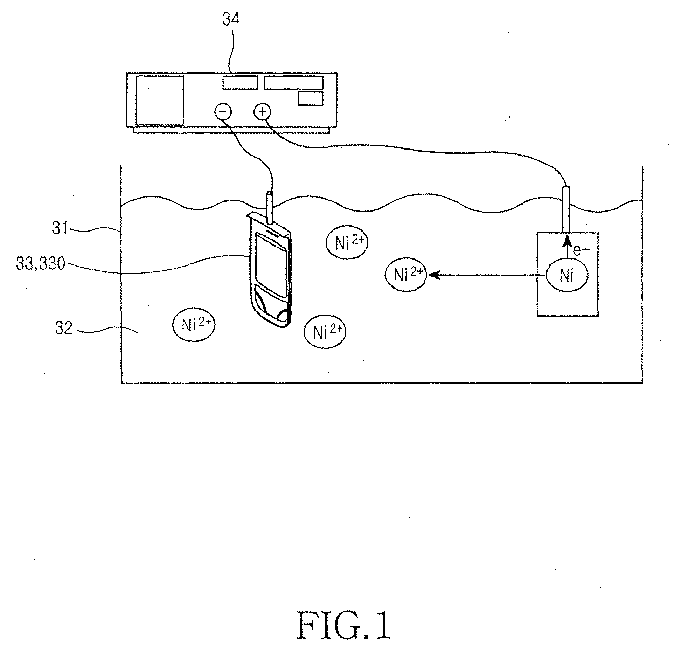

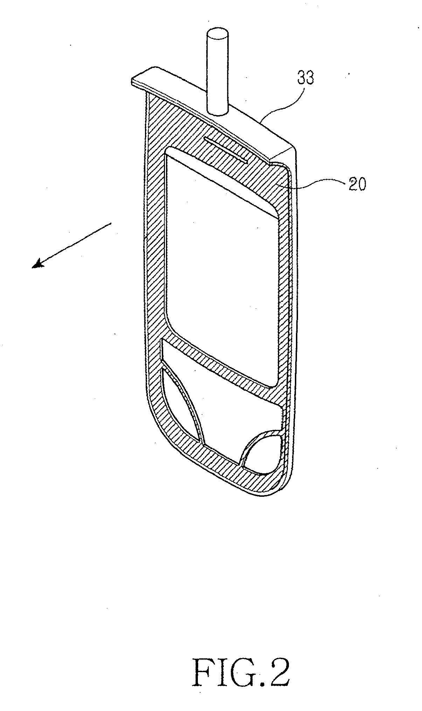

As shown in FIGS. 1 and 2, with respect to manufacturing a metal case 10 of the portable terminal, an initial metal case 20 is manufactured using an electro-forming method, and then the initial metal case 20 is trimmed, or foreign material is removed from the initial metal case 20, to produce the metal case 10 for the portable terminal.

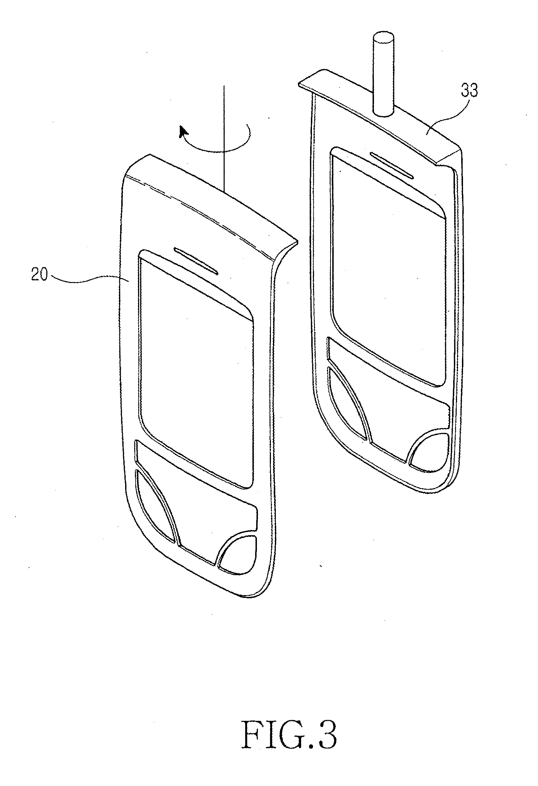

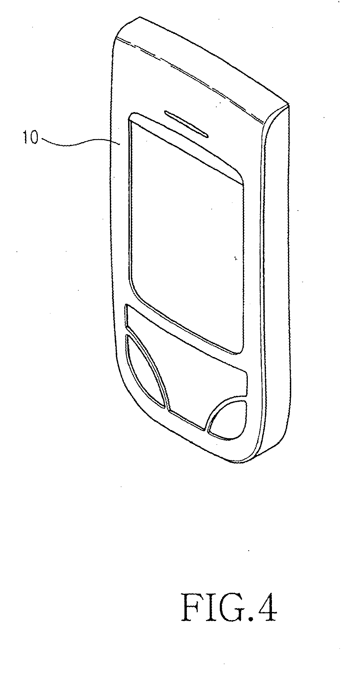

As shown in FIGS. 3 and 4, plastic is insert-injected for the inner surface of the metal case 10 for the portable terminal in order to increase rigidity of the case 10.

The initial metal case 20, for example, can have a thickness below 0.5 mm, and can be made of nickel-based metal, copper-based metal, etc. The metal case 10 for the portable terminal can be painted and insulated.

In the electro-forming method, a master mold 33 is immersed in a bath 31 containing electrolyte 32. The master mold 33 is electrically connected to a negative pole of a rectifier 34. The positive pole of the rectifier 34 can be connected to a nickel plate. The master mold 33 and the nickel plate are immersed in electrolyte 32 of the bath 31. In this state, when electricity is applied to the negative and positive poles opposed within the electrolyte 32, electrolysis occurs at the positive pole while metal ions are discharged so as to be attached to the negative pole. The metal is attached to a pattern until the master mold 33 obtains a metal layer of a predetermined thickness. Then, the metal layer is separated from the master mold 33. The separated metal layer is referred to as the initial metal case 20 and has a shape corresponding to the master mold 33.

As shown in FIGs. 2 and 3, the initial metal case 20 can have a thickness below 0.5 mm and be made of nickel-based metal material.

In this state, the initial metal case 20 can be trimmed or unnecessary foreign material and superfluity are removed from the metal case 20, thereby obtaining the shape of the metal case 10.

As shown in FIG. 4, the metal case can be painted and insulated. The metal case 10 is fixed to a mold (not shown) in order to perform the plastic insert-injection molding for the metal case 10, and then the plastic is insert-injected for the inner surface of the metal case 10.

As described above, the plastic is insert-injected for the metal case 10, so as to increase the rigidity of the metal case 10.

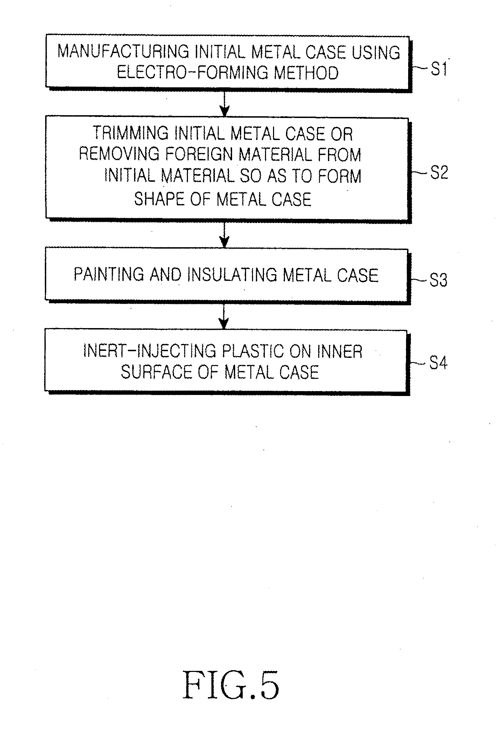

In the method of manufacturing the metal case 10 for the portable terminal, as shown in FIG 5, a nickel-based initial metal case 20 having a thickness below 0.5mm can be manufactured by using an electro-forming method (S1).

The initial metal case 20 can be trimmed or unnecessary foreign material and superfluity can be removed, thereby obtaining the shape of the metal case 10 (S2).The metal case 10 for the portable terminal can be painted and insulated (S3). The metal case 10 obtained from the step S3 is fixed to a mold (not shown), and then plastic can be insert-injected for the inner surface of the metal case 10 (S4).

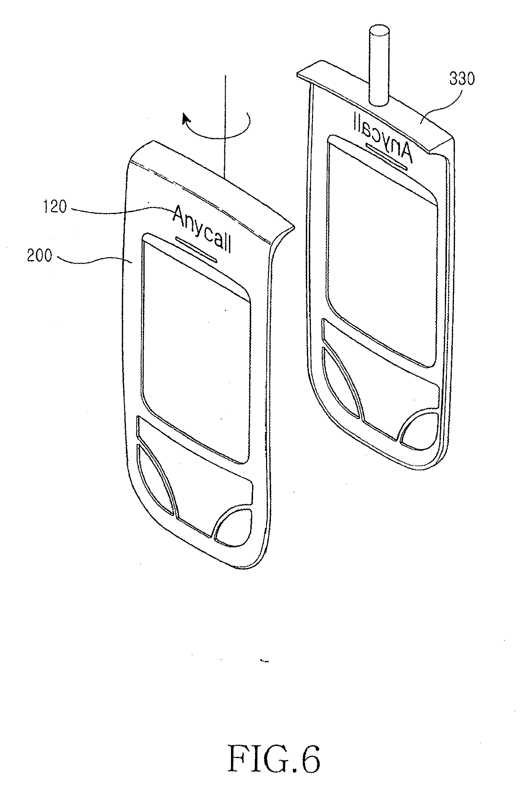

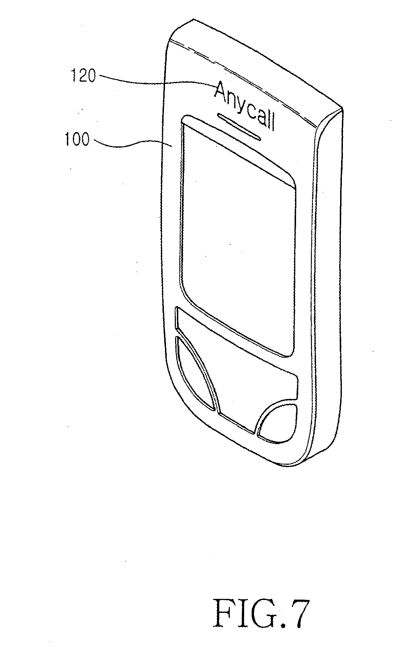

An initial metal case 200 can be manufactured using an electro-forming method, as described above, for obtaining a metal case 100, as shown in FIGs. 6 and 7.While the initial metal case 200 is being manufactured, a master mold can be manufactured so that characters 120, for example "Anycall", can be embossed on the outer surface of the initial metal case 200. The initial metal case 200 can be manufactured from nickel-based metal and have a thickness below 0.5mm.In this state, the initial metal case 200 can be trimmed, or unnecessary foreign material and superfluity can be removed from the metal case 200, thereby obtaining the shape of the metal case 100.

The metal case 100 can be painted and insulated. The metal case 100 is fixed to a mold (not shown), and then plastic can be insert-injected for the outer surface of the metal case 100.

As described above, it is possible to manufacture the metal case 100 where the interior is metal and the exterior is plastic. When plastic is insert-injected for the outer surface of the metal case 200 on which a logo character 120, etc. is embossed, the plastic injection molding material is injected for the outer surface of the case 100, and over the character 120 embossed on the outer surface of the case 100.Thus, it is possible to emboss the logo character 120 for a product on the metal case 100 of the portable terminal.

In the conventional art, a logo character for a product, etc. is separately manufactured, and is then either attached to or printed on the case of the portable terminal. However, this is disadvantageous because the logo character can be detached or erased.

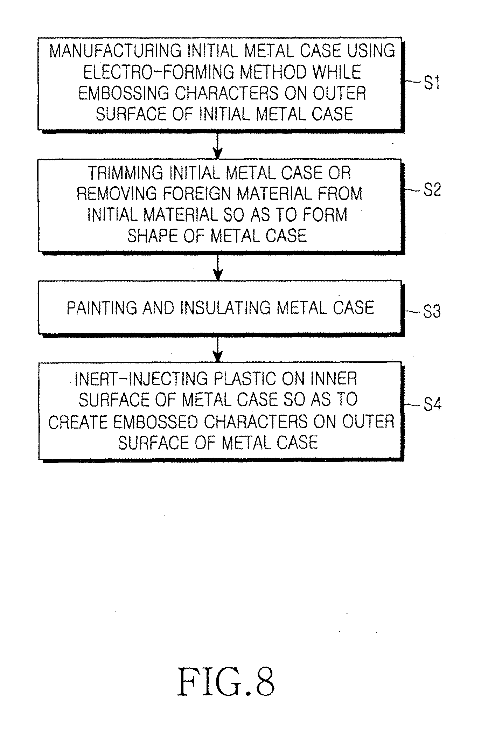

As shown in FIG 8, in manufacturing the metal case 100 for the portable terminal, an initial metal case 200 can be made of nickel-based metal having a thickness below 0.5mm by using the electro-forming method associated with FIG 1. With respect to the manufacturing of the initial metal case 200, a master mold 330 is manufactured so that a logo character 120 is embossed on the outer surface of the initial metal case 200, and then the initial metal case 200 is made having the characters 120, for example "Anycall", embossed on the outer surface thereof by using the master mold 330 (S1).

The initial metal case 200 manufactured in step S1 can be trimmed, or unnecessary foreign material and superfluity can be removed from the metal case 200, thereby obtaining the shape of the metal case 100 (S2).The metal case 100 for the portable terminal can then be painted and insulated (S3).

The metal case 100 obtained from the step S3 is fixed to a mold (not shown), and then plastic injection molding material is injected for the outer surface of the case 100, and over the character 120 embossed on the outer surface of the case 100. As a result, the logo character 120 for a product is embossed on the outer surface of the case 100 of the portable terminal (S4).

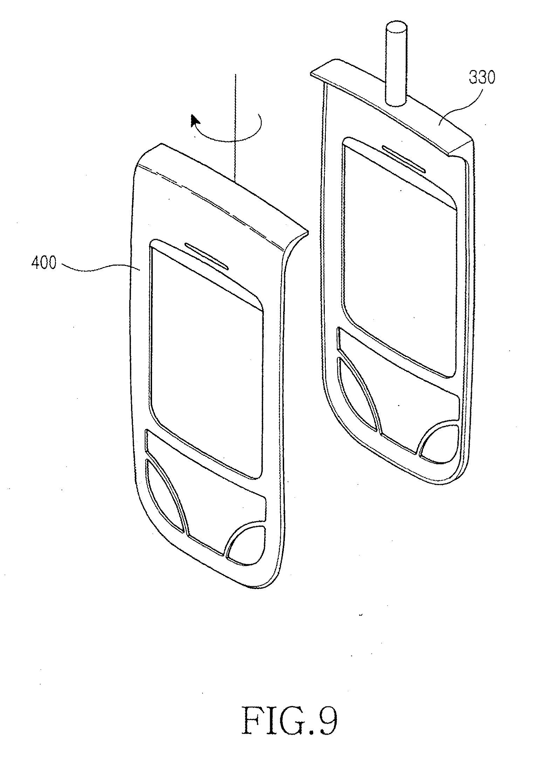

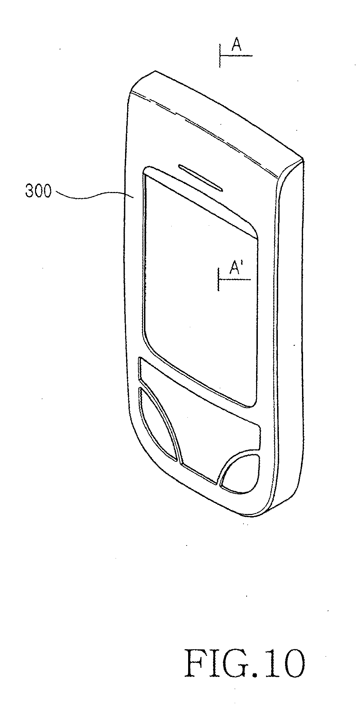

An initial metal case 400 can be manufactured by using an electro-forming method, as described above, for obtaining a metal case 300 for the portable terminal, as shown in FIGs. 9 and 10.

The initial metal case 400 can be made of nickel-based metal and have a thickness below 0.5mm.The initial metal case 400 can be trimmed or unnecessary foreign material and superfluity can be removed from the metal case 400, thereby obtaining the shape of the metal case 300.

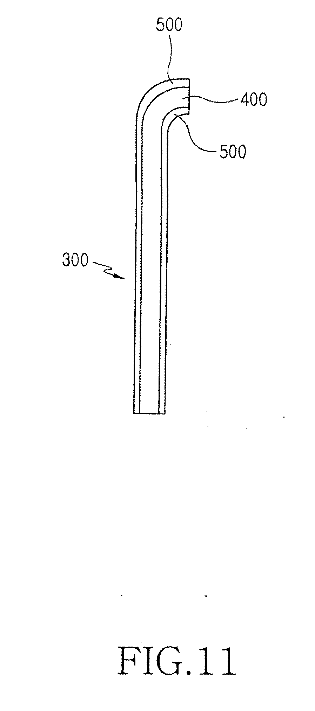

As shown in FIGS. 10 and 11, the metal case 300 is fixed to a mold (not shown), and then plastic 500 is insert-injected for all of the inner and outer surfaces of the metal case 300.

As the plastic 500 is insert-injected for the inner and outer surfaces of the metal case 300, the existing insulation process can be omitted, thereby simplifying the manufacturing processes and improving the insulation effect even further.

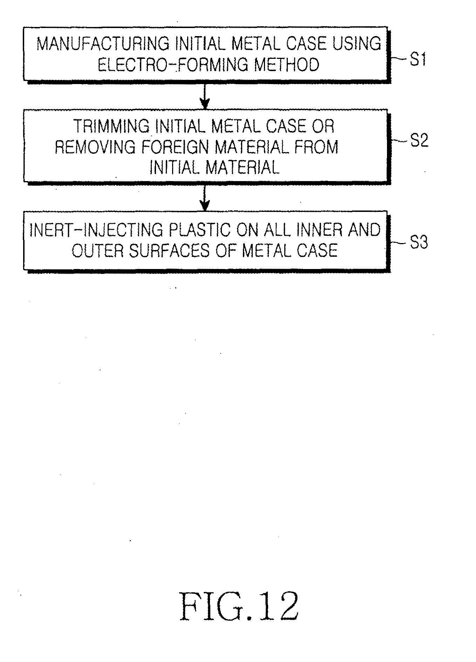

According to the method of manufacturing the metal case 300 for the portable terminal, as shown in FIG 12, the initial metal case 400 can be made of nickel-based metal and have a thickness below 0.5 mm (S1) in the above described electro-forming method associated with FIG 1. The initial metal case 400 manufactured in the step S1 can be trimmed or unnecessary foreign material and superfluity can be removed from the metal case 400, thereby obtaining the shape of the metal case 300 (S2).The metal case 300 obtained from the step S2 is fixed to a mold (not shown) in order to perform plastic insert-injection molding to the metal case 300, and then the plastic injection molding material 500 is injected for all of the inner and outer surfaces of the case 300 (S3).

As the plastic 500 is insert-injected for the inner and outer surfaces of the metal case 300, it is possible to provide constant strength to a product, thereby increasing the rigidity of the product and simplifying the manufacturing processes. Further, the thickness of the metal for the product is small, thereby reducing the manufacturing cost.

While the invention has been shown and described with reference to certain preferred embodiments thereof, it will be understood by those skilled in the art that various changes in form and details may be made therein without departing from the scope of the invention as defined by the appended claims.

## Claims

1. A method for manufacturing a metal case (10,100,300) for an electronic device such as a portable terminal, the method comprising:
manufacturing an initial metal case (20,200,400) by using an electro-forming method;
trimming the initial metal case (20,200,400) and removing foreign material from the initial metal case to obtain the metal case (10,100,300) for the electronic device; and
insert-injecting plastic material for a surface of the metal case (10,100,300) for the electronic device.

2. Method according to claim 1, the method further comprising:
painting and insulating the metal case (10,100,300).

3. The method as claimed in claim 1 or 2, wherein the manufacturing step further comprises manufacturing the initial metal case (20,200,400) with a thickness below 0.5 mm.

4. The method as claimed in claim 1 or 2, wherein the manufacturing step further comprises manufacturing the initial metal case (20,200,400) from nickel-based metal or of copper-based metal.

5. Method according to claim 1 or 2, the method further comprising:
embossing characters (120) on an outer surface of the metal case.

6. A metal case (10,100,300) for an electronic device such as a portable terminal, the metal case being manufactured by a method according to one of the preceding claims.

7. The metal case for the portable terminal as claimed in claim 6, wherein characters (120) are embossed on an outer surface of the initial metal case (20,200,400) before the plastic material is insert-injected on the outer surface of the initial metal case (20,200,400) to form the embossed characters (120).
